# EUROPEAN PATENT SPECIFICATION

(11) **EP 1 371 135 B1**
(45) Date of publication and mention of the grant of the patent: **30.11.2005**
(21) Application number: 01917108.1
(22) Date of filing: 23.03.2001
(51) Int. Cl.: H03H 9/46

(54) **FILTER DEVICE**
FILTEREINRICHTUNG
DISPOSITIF FILTRANT

(43) Date of publication of application: 17.12.2003
(73) Proprietor: Infineon Technologies AG, 81669 München (DE); Nokia Corporation, 02150 Espoo (FI)
(72) Inventor: AIGNER, Robert, 81675 München (DE); TIKKA, Pasi, D-82024 Taufkirchen (DE); ELLÄ, Juha, FIN-24800 Halikko (FI)
(74) Representative: Ginzel, Christian
(86) International application number: PCT/EP2001/003328
(87) International publication number: WO 2002/082647

(56) References cited:
- EP-A- 0 795 958
- WO-A-98/34345
- US-A- 5 847 626
- PATENT ABSTRACTS OF JAPAN vol. 2000, no. 07, 29 September 2000 (2000-09-29) & JP 2000 114917 A (KYOCERA CORP), 21 April 2000 (2000-04-21)

## Description

The present invention relates to filter devices. The present invention especially relates to acoustic wave filter devices, e.g. Surface Acoustic Wave (SAW) filter devices, and/or Bulk Acoustic Wave (BAW) filter devices.

The need for using miniature and high performance filters in wireless communication devices has led to the widespread usage of Surface Acoustic Wave (SAW) filters. In addition to Surface Acoustic Wave (SAW) filters Bulk Acoustic Wave (BAW) filters can also be used. Bulk Acoustic Wave (BAW) filters typically include several Bulk Acoustic Wave (BAW) resonators. In a Bulk Acoustic Wave (BAW) filter, acoustic waves propagate in a direction that is perpendicular to the filter's layer surfaces. In contrast, acoustic waves which propagate within a Surface Acoustic Wave (SAW) filter do so in a direction that is parallel to the layer surfaces of the filter.

It is known to fabricate monolithic filters that include at least a Bulk Acoustic Wave (BAW) resonator device (also known in the art as "Thin Film Bulk Acoustic Wave Resonators (FBARs)"). By example, Bulk Acoustic Wave (BAW) resonators typically include two electrodes and a single piezoelectric layer that is disposed between the two electrodes. One or more acoustic isolation layers may also be employed between the piezoelectric layer and a substrate of the respective devices.

Bulk Acoustic Wave (BAW) filters can be fabricated to include various known types of Bulk Acoustic Wave (BAW) resonators. These known types of Bulk Acoustic Wave (BAW) resonators comprise three basic portions. A first one of the portions, which is used to generate acoustic waves, includes an acoustically-active piezoelectric layer. This layer may comprise, by example, zinc-oxide (ZnO), aluminum nitride (AlN), zinc-sulfur (ZnS), or any other suitable piezoelectric material that can be fabricated as a thin film. A second one of the portions includes electrodes that are formed on opposite sides of the piezoelectric layer. A third portion of the Bulk Acoustic Wave (BAW) resonator includes a mechanism for acoustically isolating the substrate from vibrations produced by the piezoelectric layer. Bulk Acoustic Wave (BAW) resonators are typically fabricated on silicon, gallium arsenide, or glass substrates using thin film technology (e.g., sputtering, chemical vapor deposition, etc.). Bulk Acoustic Wave (BAW) resonators exhibit series and parallel resonances that are similar to those of, by example, crystal resonators. Resonant frequencies of Bulk Acoustic Wave (BAW) resonators can typically range from about 0.5 GH to 5 GHz, depending on the layer thicknesses of the devices.

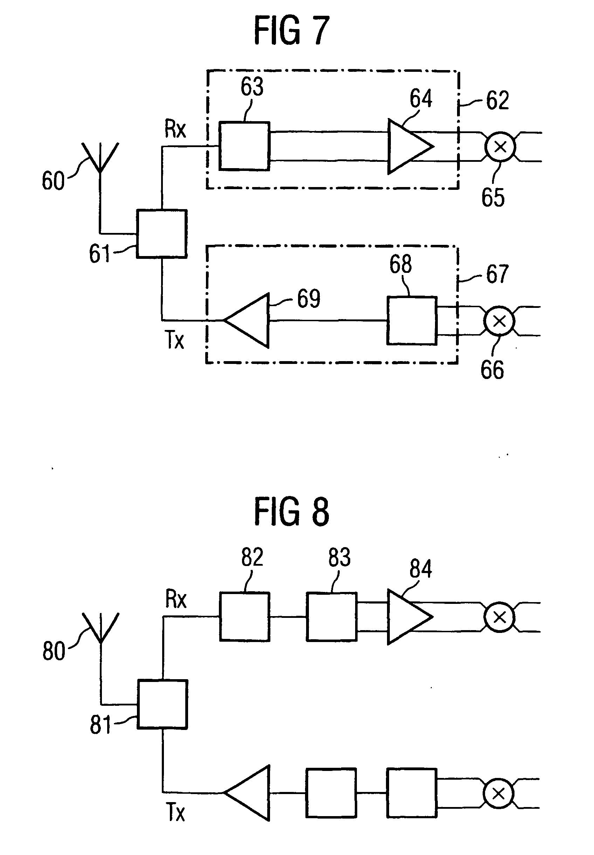

Fig. 8 shows an example of an acoustic wave filter device used in a mobile application. Generally, an RF signal is input from an antenna 80 through a switch 81 and guided to an amplifier 84 via an acoustic wave filter device 82, for example a bulk acoustic wave filter device (BAW), having unbalanced terminals and a characteristic impedance of 50 Ω. In same cases the amplifier 84 is a low noise amplifier having balanced terminals. This amplifier often has a characteristic impedance of about 150-200 Ω·

For this reason a matching circuit for impedance conversion and an unbalanced-to-balanced transformer have been required for connection to the amplifier side. A unbalanced-to-balanced transformer circuit 83 (usually called a balun) has been used for that function. However, the use of a balun 83 considerably increases the number of parts and cost, especially since baluns 83 are usually discrete components that are not integrated with the rest of the filter system 82 or the amplifier 84 see, e.g., JP-2000-114917-A. Accordingly, there is a demand to decrease the number of components and achieve integrated unbalanced-to-balanced acoustic wave filter device.

The foregoing and other problems are overcome by a filter device as specified in independent claim 1. Further advantageous features, aspects and details of the invention are evident from the dependent claims, the description and the accompanying drawings. The claims are intended to be understood as a first non-limiting approach of defining the invention in general terms.

The present invention provides a filter device comprising:
a first filter unit comprising at least one series resonator and at least one shunt resonantor in a ladder configuration and comprising one unbalanced terminal; and
a second filter unit connected to the first filter unit via a series resonator of the the first filter unit, said second filter unit comprising at least four resonators in a lattice configuration and comprising two balanced terminals.

The present invention provides a filter device constructed of a combined ladder and lattice filter topology. The filter device according to the present invention synergetically combines the good features of both types of filters. The first filter unit in ladder configuration has a finite stopband attenuation, while the second filter unit has, at least in theory, an infinite stopband attenuation far from the passband. The filter device according to the present invention basically has also an infinite stopband attenuation far from the passband.

Using the filter device according to the present invention an integrated unbalanced-to-balanced filter device can be realized. Accordingly, a substancial decrease in the number of components can be achieved. Furthermore, the filter device according to the present invention can be integrated with further components, preferably active RF-components, on a single chip.

According to a preferred embodiment the filter device according to the present invention is an acoustic wave filter, especially a Surface Acoustic Wave (SAW) filter comprising surface acoustic wave resonators, or, even more preferred, a Bulk Acoustic Wave (BAW) filter comprising bulk acoustic wave resonators.

According to a further preferred embodiment first filter unit comprises the same types of resonators as the second filter unit. Especially, the first and the second filter unit can be fabricated using only two types of resonators, series and shunt resonators. Thereby, it is preferred that the series resonators in the first filter unit and the series resonators in the second filter unit exhibit substantially equal resonance frequencies. Furthermore, it is preferred that the shunt resonators in the first filter unit and the shunt resonators in the second filter unit exhibit substantially equal resonance frequencies.

According to a further preferred embodiment the first filter unit comprises an odd number of resonators, preferably at least 3 or 5 resonators (t-topology or π-topology).

Some of the above indicated and other more detailed aspects of the invention will be described in the following description and partially illustrated with reference to the figures. Therein:
- Fig. 1: shows schematically a cross-section of an exemplary Bulk Acoustic Wave (BAW) resonator that includes an air gap;
- Fig. 2: shows a top view of the Bulk Acoustic Wave (BAW) resonator of Fig. 1;
- Fig. 3: shows schematically a cross-section of an exemplary Bulk Acoustic Wave (BAW) resonator that includes an acoustic mirror;
- Fig. 4: shows a filter device according to a first embodiment of the present invention;
- Fig. 5: shows a comparison of different filter topologies;
- Fig. 6: shows a filter device according to a further embodiment of the present invention;
- Fig. 7: shows filter devices according to a further embodiment of the present invention integrated with an a low noise amplifier (LNA) or a power amplifier on a single chip; and.
- Fig. 8: shows an example of a surface acoustic wave filter device used in a mobile environment.

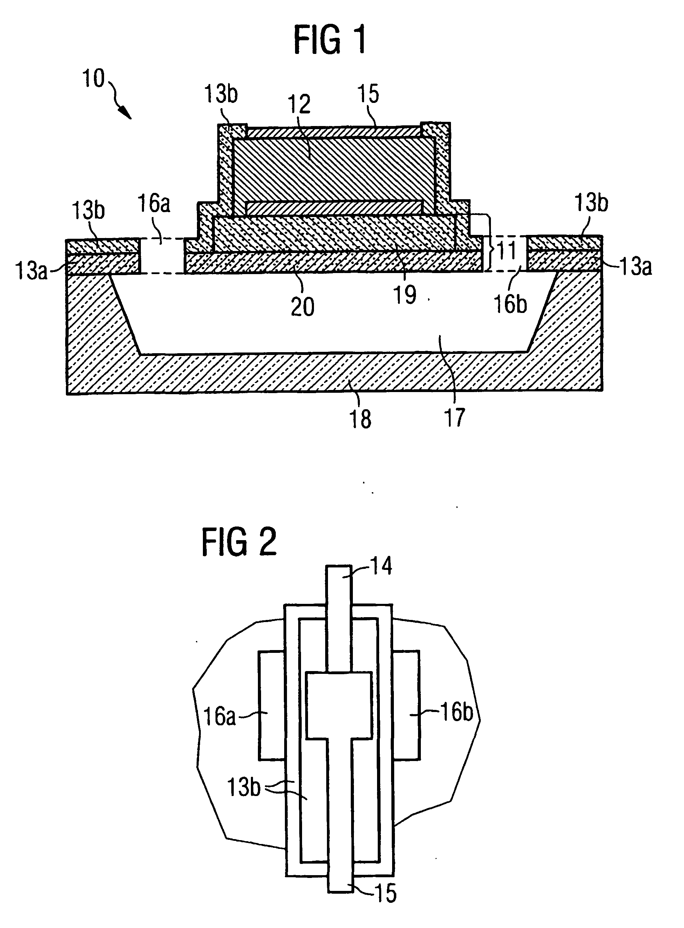

Figs. 1 and 2 show a cross-section (side view) and a top view, respectively, of a Bulk Acoustic Wave (BAW) resonator 10 having a membrane or bridge structure 11. The Bulk Acoustic Wave (BAW) resonator 10 comprises a piezoelectric layer 12, a first protective layer 13a, a second protective layer 13b, a first electrode 14, a second electrode 15, the membrane 11, etch windows 16a and 16b, an air gap 17, and a substrate 18. The piezoelectric layer 12 comprises, by example, a piezoelectric material that can be fabricated as a thin film such as, by example, zinc-oxide (Zno), or aluminum-nitride (AlN).

The membrane 11 comprises two layers, namely, a top layer 19 and a bottom layer 20. The top layer 19 is made of, by example, poly-silicon or aluminum-nitride (AlN), and the bottom layer 20 is made of, by example, silicon-dioxide (SiO₂) or gallium arsenide (GaAs). The substrate 18 is comprised of a material such as, by example, silicon (Si), SiO₂, GaAs, or glass. Through the etch windows 16a and 16b, a portion of the substrate 18 is etched to form the air gap 17 after the membrane layers have been deposited over the substrate 18.

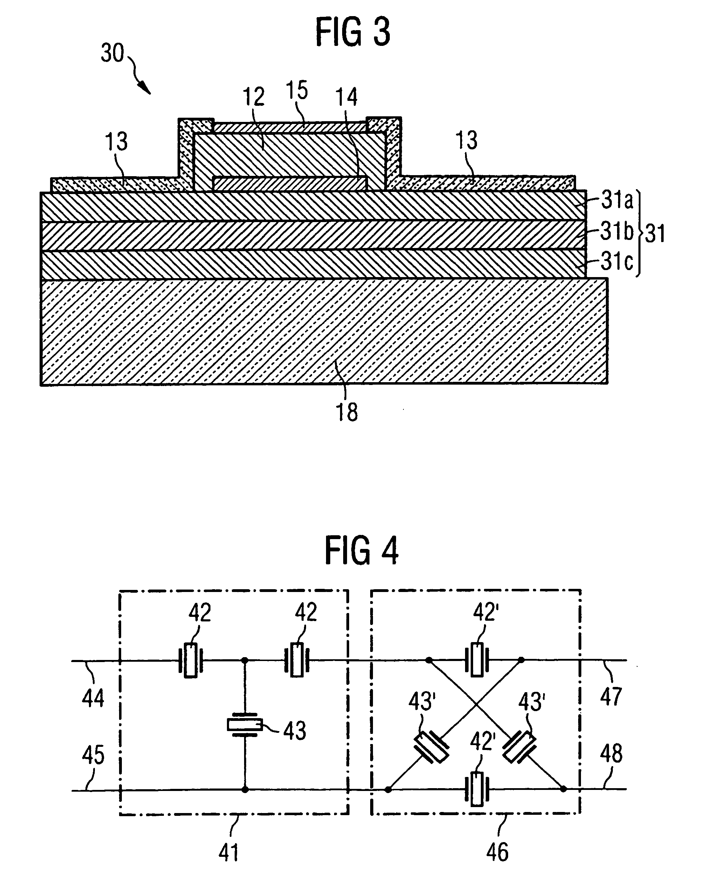

In Fig. 3, another Bulk Acoustic Wave (BAW) resonator 30 is shown. This resonator 30 has a similar structure as that of the Bulk Acoustic Wave (BAW) resonator 10 of Fig. 1, except that only a single protective layer 13 is provided, and the membrane 11 and the air gap 17 are replaced with an acoustic mirror 31 which acoustically isolates vibrations produced by the piezoelectric layer 12 from the substrate 18.

The acoustic mirror 31 comprises a number of layers with alternating high and low acoustic impedances arrenged so that a reflection of the acoustic wave at the mirror-resonator interface is obtained. The acoustic mirror 31 shown in Fig. 3 comprises three layers, namely a top layer 31a, a middle layer 31b, and a bottom layer 31c. Each layer 31a, 31b and 31c has a thickness that is, by example, approximately equal to one quarter wavelength. The top layer 31a and bottom layer 31c are made of materials having low acoustic impedances such as, by example, silicon (Si), poly-silicon, aluminum (Al), or a polymer. Furthermore, the middle layer 31b is made of a material having a high acoustic impedance such as, by example, gold (Au), molybdenum (Mo), or tungsten (W). The substrate 18 may be comprised of various high acoustic impedance materials or low acoustic impedance materials (e.g., Si, SiO₂, GaAs, glass, or a ceramic material).

Fig. 4 shows a filter device according to a first embodiment of the present invention. The filter device shown in Fig. 4 comprises two filters units that are directly connected via a series resonator of the first filter unit. The first filter unit 41 preferably comprises an odd number of resonators, three in the present example, in a ladder configuration. The first filter unit 41 is Bulk Acoustic Wave (BAW) filter comprising two types of bulk acoustic wave resonators, series resonators 42 and shunt resonators 43. Preferably, the first filter unit 41 is a Bulk Acoustic Wave (BAW) filter comprising bulk acoustic wave resonators as shown in Figs. 1 to 3.

Furthermore, the first filter unit 41 comprises one unbalanced terminal 44, to which, for example, the output signal of an antenna can be connected. In addition to the terminal 44 the first filter unit 41 comprises the terminal 45 which is connected to ground in the present example.

The second filter unit 46 comprises four resonators in a lattice configuration. Like the first filter unit 41 the second filter unit 46 is Bulk Acoustic Wave (BAW) filter comprising two types of bulk acoustic wave resonators, series resonators 42' and shunt resonators 43'. Thereby, the series resonators 42 in the first filter unit 41 and the series resonators 42' in the second filter unit 46 exhibit substantially equal resonance frequencies. The same applies to the shunt resonators 43 in the first filter unit 41 and the shunt resonators 43' in the second filter unit 46 which also exhibit substantially equal resonance frequencies. Furthermore, the second filter unit 46 comprises two balanced terminal 47 and 48, to which, for example, a low noise amplifier (LNA) can be connected.

The second filter unit 46 is connected to the first filter unit 41 via a series resonator 42 of the the first filter unit 41 because otherwise an impedance mismatch between the two filter units would arise. Due to the fact that the first filter unit 41 ends with a series resonator and not with shunt resonator, the first filter unit 41 and the second filter unit 46 are well matched.

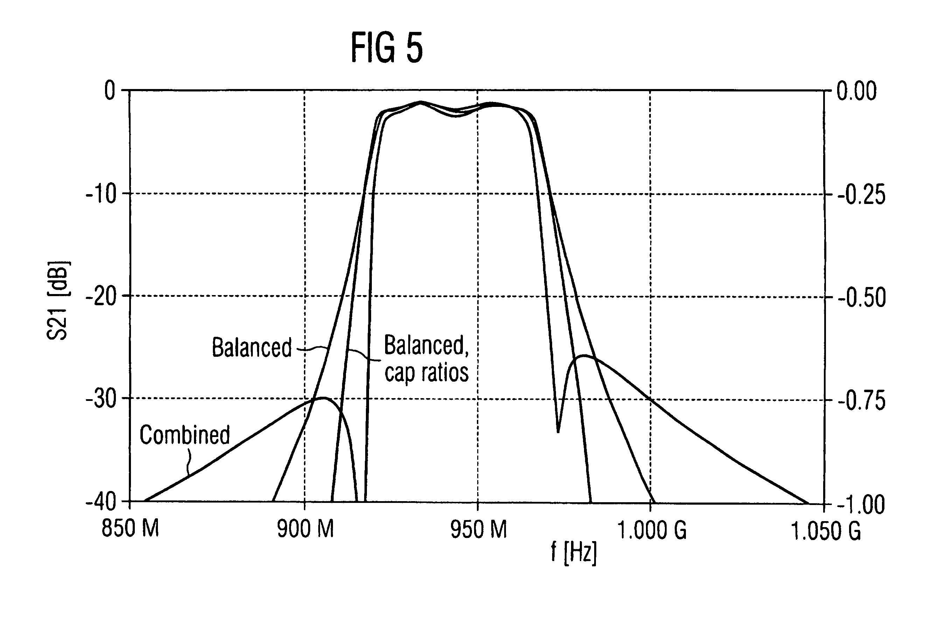

The filter device according to the present invention exhibits an excellent response, especially when the node between the loads at the balanced side is not grounded (floating). Furthermore, the filter device according to the present invention has steeper transition from the passband to stopband than a balanced filter or a balanced filter with different capacitance ratios. Accordingly, the filter device according to the present invention exhibits a better selectivity than the other two filters. The results of a comparison are shown in Fig. 5.

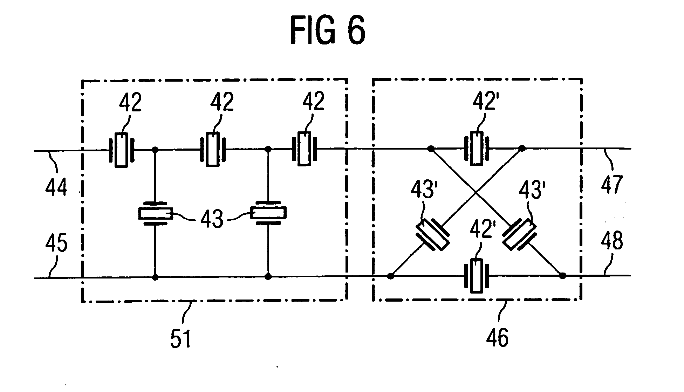

Fig. 6 shows a filter device according to a second embodiment of the present invention. The filter device shown in Fig. 6 also comprises two filter units that are directly connected via a series resonator of the first filter unit. The first filter unit 51 preferably comprises an odd number of resonators, five in this example, in a ladder configuration. Again, the first filter unit 51 is Bulk Acoustic Wave (BAW) filter comprising two types of bulk acoustic wave resonators, series resonators 42 and shunt resonators 43.

Fig. 7 shows filter devices according to a further embodiment of the present invention which are integrated with an a low noise amplifier (LNA) or a power amplifier on a single chip. Fig. 7 shows schematically the reception side (Rx) as well as the transmission side (Tx) of a mobile telecommunication device.

A signal received from the antenna 60 is guided via a switch 61 to the chip 62 which integrates a filter device 63 and a low noise amplifier (LNA) 64. The filter device 63 exhibits a first filter unit comprising an odd number of resonators in a ladder configuration and a second filter unit comprising at least four resonators in a lattice configuration. The filter device 63 filters the signal from the antenna and performs a conversion from an unbalanced to a balanced signal. The resulting balanced signal is amplified by the low noise amplifier (LNA) 64 and guided to a mixer 65.

A signal that is to be transmitted via the antenna 60 is produced by a mixer 66 and guided to the chip 67 which integrates a filter device 68 and a power amplifier 69. The filter device 68 also exhibits a first filter unit comprising an odd number of resonators in a ladder configuration and a second filter unit comprising at least four resonators in a lattice configuration. The filter device 68 filters the signal from the mixer and performs a conversion from an balanced to an unbalanced signal. The resulting unbalanced signal is amplified by the power amplifier 69 and guided to the antenna 60 via the switch 61.

Using the filter device according to the present invention an integrated unbalanced-to-balanced filter device can be realized. Accordingly, a substancial decrease in the number of components can be achieved. Furthermore, the filter device according to the present invention can be integrated with further components, preferably a low noise amplifier (LNA), on a single chip. In addition, the filter device according to the present invention preferably uses BAW filters, because BAW filters are more cost effective than existing SAW filters.

## Claims

1. A filter device, said filter device comprising:
a first filter unit (41) comprising at least one series resonator (42) and at least one shunt resonantor (43) in a ladder configuration and comprising one unbalanced terminal (44); and
a second filter unit (46) connected to the first filter unit (41) via a series resonator (42) of the first filter unit (41), said second filter unit (46) comprising at least four resonators in a lattice configuration and comprising two balanced terminals (47, 48).

2. A filter device as set forth in claim 1, wherein said filter device is an acoustic wave filter.

3. A filter device as set forth in claim 1 or 2, wherein said filter device is a Surface Acoustic Wave (SAW) filter comprising surface acoustic wave resonators.

4. A filter device as set forth in of the preceeding claims, wherein said filter device is a Bulk Acoustic Wave (BAW) filter comprising bulk acoustic wave resonators.

5. A filter device as set forth in of the preceeding claims, wherein the first filter unit (41) comprises an odd number of resonators.

6. A filter device as set forth claim 5, wherein the first filter unit (41) comprises at least 3, preferably at least 5 resonators.

7. A filter device as set forth in of the preceeding claims, wherein first filter unit (41) comprises the same types of resonators as the second filter unit.

8. A filter device as set forth in of the preceeding claims, wherein the series resonators (42) in the first filter unit (41) and the series resonators (42') in the second filter unit (46) exhibit substantially equal resonance frequencies.

9. A filter device as set forth in of the preceeding claims, wherein the shunt resonators (43) in the first filter unit (41) and the shunt resonators (43') in the second filter unit (46) exhibit substantially equal resonance frequencies.

10. A filter device as set forth in of the preceeding claims, wherein the filter device is integrated with active RF-components, preferably an amplifier, on a single chip.

## Patentansprüche

1. Eine Filtervorrichtung, wobei die Filtervorrichtung umfasst:
eine erste Filtereinheit (41) mit mindestens einem Reihenresonator (42) und mindestens einem Shunt-Resonator (43) in einer Leiteranordnung und mit einem unsymmetrischen Anschluss (44); und
eine zweite Filtereinheit (46), die mit der ersten Filtereinheit (41) über einen Reihenresonator (42) der ersten Filtereinheit (41) verbunden ist, wobei die zweite Filtereinheit (46) mindestens vier Resonatoren in einer Kreuzanordnung und zwei symmetrische Anschlüsse (47, 48) umfasst.

2. Eine Filtervorrichtung nach Anspruch 1, wobei die Filtervorrichtung ein akustisches Wellenfilter ist.

3. Eine Filtervorrichtung nach Anspruch 1 oder 2, wobei die Filtervorrichtung ein akustisches Oberflächenwellen (SAW)-Filter mit akustischen Oberflächenwellen-Resonatoren ist.

4. Eine Filtervorrichtung nach einem der vorhergehenden Ansprüche, wobei die Filtervorrichtung ein akustisches Volumenwellen (BAW)-Filter mit akustischen Volumenwellen-Resonatoren ist.

5. Eine Filtervorrichtung nach einem der vorhergehenden Ansprüche, wobei die erste Filtereinheit (41) eine ungerade Anzahl von Resonatoren umfasst.

6. Eine Filtervorrichtung nach Anspruch 5, wobei die erste Filtereinheit (41) mindestens drei, vorzugsweise mindestens fünf Resonatoren umfasst.

7. Eine Filtervorrichtung nach einem der vorhergehenden Ansprüche, wobei die erste Filtereinheit (41) dieselben Resonatortypen wie die zweite Filtereinheit umfasst.

8. Eine Filtervorrichtung nach einem der vorhergehenden Ansprüche, wobei die Reihenresonatoren (42) in der ersten Filtereinheit (41) und die Reihenresonatoren (42') in der zweiten Filtereinheit (46) im Wesentlichen gleiche Resonanzfrequenzen aufweisen.

9. Eine Filtervorrichtung nach einem der vorhergehenden Ansprüche, wobei die Shunt-Resonatoren (43) in der ersten Filtereinheit (41) und die Shunt-Resonatoren (43') in der zweiten Filtereinheit (46) im Wesentlichen gleiche Resonanzfrequenzen aufweisen.

10. Eine Filtervorrichtung nach einem der vorhergehenden Ansprüche, wobei die Filtervorrichtung mit aktiven RF-Komponenten, vorzugsweise einem Verstärker, auf einem einzigen Chip integriert ist.

## Revendications

1. Dispositif formant filtre, le dispositif formant filtre comportant :
une première unité (41) formant filtre comportant au moins un résonateur (42) série et au moins un résonateur (43) de dérivation suivant une configuration en échelle et comportant une borne (44) déséquilibrée ; et
une deuxième unité (46) formant filtre connectée à la première unité (41) formant filtre par l'intermédiaire d'un résonateur (42) série de la première unité (41) formant filtre, la deuxième unité (46) formant filtre comportant au moins quatre résonateurs suivant une configuration en réseau et comportant deux bornes (47, 48) équilibrées.

2. Dispositif formant filtre suivant la revendication 1, dans lequel le dispositif formant filtre est un filtre d'onde acoustique.

3. Dispositif formant filtre suivant la revendication 1 ou 2, dans lequel le dispositif formant filtre est un filtre à onde acoustique de surface (SAW) comportant des résonateurs d'onde acoustique de surface.

4. Dispositif formant filtre suivant l'une quelconque des revendications précédentes, dans lequel le dispositif formant filtre est un filtre d'onde acoustique de volume (BAW) comportant des résonateurs d'onde acoustique de volume.

5. Dispositif formant filtre suivant l'une quelconque des revendications précédentes, dans lequel la première unité (41) formant filtre comporte un nombre impair de résonateurs.

6. Dispositif formant filtre suivant la revendication 5, dans lequel la première unité (41) formant filtre comporte au moins trois résonateurs, de préférence au moins cinq résonateurs.

7. Dispositif formant filtre suivant l'une des revendications précédentes, dans lequel la première unité (41) formant filtre comporte les mêmes types de résonateurs que la deuxième unité formant filtre.

8. Dispositif formant filtre tel que défini dans les revendications précédentes, dans lequel les résonateurs (42) série dans la première unité (41) formant filtre et les résonateurs (42') série dans la deuxième unité (46) formant filtre présentent des fréquences de résonance sensiblement égales.

9. Dispositif formant filtre tel que défini dans les revendications précédentes, dans lequel les résonateurs de dérivation (43) dans la première unité (41) formant filtre et les résonateurs (43') de dérivation dans la deuxième unité (46) formant filtre présentent des fréquences de résonance sensiblement égales.

10. Dispositif formant filtre suivant les revendications précédentes, dans lequel le dispositif formant filtre est intégré avec des composants HF actifs, de préférence un amplificateur, sur une puce unique.
